(19) Europäisches Patentamt

European Patent Office

Office européen des brevets

(11) **EP 0 658 980 B1**

(12) **EUROPÄISCHE PATENTSCHRIFT**

(45) Veröffentlichungstag und Bekanntmachung des Hinweises auf die Patenterteilung:
**24.06.1998 Patentblatt 1998/26**

(51) Int Cl.<sup>6</sup>: **H03K 17/95**

(21) Anmeldenummer: **94117964.0**

(22) Anmeldetag: **15.11.1994**

(54) **Schaltungsanordnung zur Signalaufbereitung für einen eine Induktivität umfassenden Sensor**

Signal-processing circuit for an inductive sensor

Circuit de traitement pour un capteur inductif

(84) Benannte Vertragsstaaten:
**DE FR IT SE**

(30) Priorität: **14.12.1993 DE 4342585**

(43) Veröffentlichungstag der Anmeldung:
**21.06.1995 Patentblatt 1995/25**

(73) Patentinhaber: **ROBERT BOSCH GMBH**
**70442 Stuttgart (DE)**

(72) Erfinder: **Schneider, Thomas, Dipl.-Ing.**
**D-71706 Markgroeningen (DE)**

(56) Entgegenhaltungen:
FR-A- 2 559 618        FR-A- 2 646 298
GB-A- 2 116 325        US-A- 3 794 855

## Beschreibung

### Stand der Technik

Die Erfindung geht aus von einer Schaltungsanordnung zur Signalaufbereitung für einen Induktivsensor nach der Gattung des Hauptanspruchs.

Es ist bekannt, Induktivsensoren für eine Vielzahl von verschiedenartigen Meßwerterfassungen einzusetzen, insbesondere im Zusammenhang mit der Erkennung der Lage eines beweglichen Teiles oder bei der Drehzahlerfassung, beispielsweise bei der Erfassung von Raddrehzahlen in Antiblockiersystemen (ABS) oder auch bei der Erfassung der Drehzahl der Kurbel- oder Nockenwelle einer Brennkraftmaschine.

Da die Ausgangssignale der Induktivsensoren stark von der Geschwindigkeit der vorbeibewegten Teile sowie vom Abstand zwischen den abzutastenden Teilen und dem Sensor selbst abhängt, ist es erforderlich, diese Ausgangssignale in geeigneter Weise aufzubereiten. Es ist dabei beispielsweise aus der DE-OS 32 08 262 bekannt, die Ausgangssignale eines Induktivsensors mit Hilfe einer Schaltungsanordnung, die unter anderem Stromspiegel umfaßt, so aufzubereiten, daß eine zuverlässige Weiterverarbeitung möglich ist. Bei der bekannten Schaltung ist jedoch nicht die Signalverstärkung der eigentliche Kern der Signalverarbeitung, sondern es wird die sogenannte Eigenverstellung durch anpassung von Schwellwerten an die Signalhöhe verringert. Da das Signal dabei nicht verstärkt wird, können bei kleinen Geschwindigkeiten der abzutastenden Teile Probleme auftreten, da dann das auszuwertende Signal zu klein wird.

Eine weitere Schaltungsanordnung zur Signalaufbereitung für einen, eine Induktivität umfassenden Sensor, beispielsweise einen Sensor zur Abtastung eines bewegbaren Teiles, insbesondere eines Drehzahlsensors ist aus der US-A-3 794 855 bekannt. Diese bekannte Schaltungsanordnung weist eine Transistoranordnung mit zwei Transistoren auf, bei der der Kollektor des ersten Transistors mit der Basis verbunden ist und die Kollektoren der beiden Transistoren über Widerstände an Versorgungsspannung liegen. Die Emitter der Transistoren sind untereinander verbunden und die Sensorspule liegt zwischen den Basen der Transistoren. Durch diese Beschaltung bewirkt der zweite Transistor eine Verstärkung des Sensormeßstromes.

### Vorteile der Erfindung

Die erfindungsgemäße Schaltungsanordnung zur Signalaufbereitung für einen Induktivsensor mit den Merkmalen des Anspruchs 1 hat den Vorteil, daß auch bei kleinen Geschwindigkeiten bzw. bei kleinen Drehzahlen sowie bei großem Abstand zwischen dem Sensor und den abzutastenden Teilen ein Signal erhalten wird, dessen Höhe eine sichere Weiterverarbeitung erlaubt, außerdem ist das erhaltene Signal sehr störunempfindlich. Erzielt werden diese Vorteile durch eine geeignete Signalstromverstärkung. Diese Signalstromverstärkung wird mit Hilfe einer Schaltung erzielt, der die Induktivität des Sensors direkt zugeordnet ist.

Vorteilhafte Ausgestaltungen der Erfindung werden durch die in den Unteransprüchen angegeben Maßnahmen erzielt. Dabei ist beispielsweise von Vorteil, daß die Sensorspule kleiner als bei bekannten Systemen sein kann. Weiterhin ist vorteilhaft, daß der Sensor und die Auswerteschaltung in einer Einheit integriert werden können und daß infolge der Stromauswertung nur eine Zweidrahtschnittstelle benötigt wird.

Besonders vorteilhaft ist, daß eine einfache Fehlerüberwachung bzw. Erkennung durch die Überwachung der Signalpegel möglich ist.

### Zeichnung

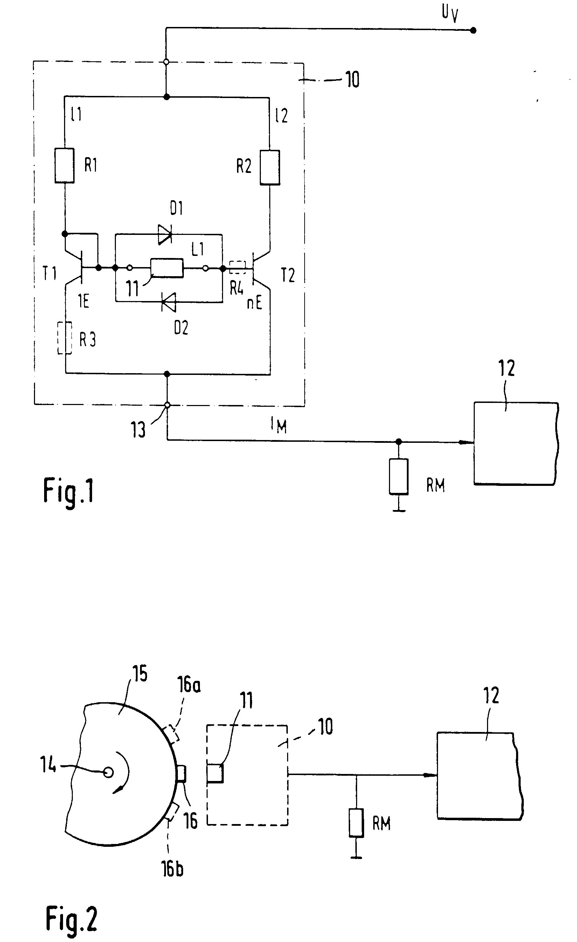

Die Erfindung ist in der Zeichnung dargestellt und wird in der nachfolgenden Beschreibung näher erläutert. Es zeigt dabei Figur 1 die Schaltungsanordnung eines Ausführungsbeispieles der Erfindung, in Figur 2 ist schematisch dargestellt, wie der Sensor samt Schaltungsanordnung nach Figur 1 zur Erfassung der Drehzahl eines rotierenden Teiles, beispielsweise eines Rades oder einer Geberscheibe eingesetzt werden kann.

### Beschreibung des Ausführungsbeispieles

In Figur 1 ist die Sensoreinheit 10, die die Sensorspule 11 mit der Induktivität L1 sowie die zugehörige Stromspiegelschaltung umfaßt einerseits an die Spannungsversorgung, an der die Spannung Uv zugeführt wird angeschlossen, während die andere Seite der Sensoreinheit 10 über den Meßwiderstand RM auf Masse geschaltet ist und außerdem mit einer Signalauswerteeinheit, beispielsweise dem Steuergerät 12 eines Kraftfahrzeuges verbunden ist.

Die Schaltungsanordnung zur Signalaufbereitung umfaßt neben der Sensorspule 11 zwei Transistoren T1, T2, die als Stromspiegel wirken und jeweils mit der Basis an eine der beiden Enden der Spule 11 angeschlossen sind. Die Basis des Transistors T1 ist ausserdem noch mit dem Emitter von T1 verbunden.

Die Kollektoren der beiden Transistoren T1, T2 sind über Widerstände R1 bzw. R2 an die Versorgungsspannung Uv gelegt, die Emitter der beiden Transistoren TI bzw. T2 sind mit dem Meßwiderstand RM verbunden. Der Kollektor des Transistors TI ist mit der Basis des Transistors T1 verbunden.

Parallel zur Spule 11 mit der Induktivität L1 sind zwei antiparallel geschaltete Dioden D1, D2 geschaltet. Die beiden Transistoren T1 bzw. T2 sind beim Ausführungsbeispiel npn-Transistoren. Es ist eine entsprechend abgeänderte Schaltung auch mit pnp-Transistoren aufbaubar.

Bei der dargestellten Schaltung fließt durch den Widerstand R1 und den Transistor T1 der Strom I1. Dieser Strom I1 wird über die Spule 11 mit der Induktivität L1 hinweg zum Transistor T2 gespiegelt. Die beiden Transistoren T1 und T2 stellen also eine Stromspiegelschaltung dar. Der Strom I2, der durch den Widerstand R2 sowie den Transistors T2 fließt ist vom Emitterverhältnis der Transistoren T2 zu T1 abhängig, es gilt:

$$I2 = n * I1$$

wobei n das Emitterverhältnis von Transistor T2 zu Transistor T1 ist.

Der Transistor T2 wird im aktiven Bereich betrieben und kann durch kleinste Basisstromänderungen gesteuert werden. Wird in die Spule 11 infolge des Vorbeibewegens eines Körpers, der die magnetischen Bedingungen an der Spule 11 beeinflußt, eine Spannung bzw. ein Strom induziert, so überlagert sich der Strom dem Basisgrundstrom des Transistors T2 und steuert den Transistor T2 auf bzw. zu. Der Strom I2 ändert sich dabei mit dem Stromverstärkungsfaktor des Transistors T2. Es findet also eine effektive Stromverstärkung statt.

Die Stromänderung wird letztendlich zur Auswertung herangezogen. Über die Zweidrahtschnittstelle 13 sowie die daran angeschlossene Leitung wird der Strom bzw. die Stromänderung übertragen und wird dann auf der Empfangsseite am Meßwiderstand RM erkannt und im Steuergerät 12 ausgewertet. Wesentlich ist, daß bereits verstärkte Signale übertragen werden, damit ist die übertragene Signalleistung höher als bei bekannten Induktivsensoren, es wird daher eine besonders gute Störsicherheit erzielt.

Die beiden Dioden D1 und D2 begrenzen die Spannung über der Spule 11, sodaß ein optimaler Spannungsbereich nicht verlassen wird. Der Widerstand R2 begrenzt den Strom I2 wenn der Transistor T2 voll aufgesteuert, also in leitendem Zustand ist.

Die Stromspiegelschaltung einschließlich der Spule 11 können als einziges Bauelement, als Sensoreinheit aufgebaut werden, es ist also eine Integration der Schaltung in den Sensor selbst möglich. Da der Strom mit Hilfe des Transistors T2 verstärkt wird, kann die Spule 11 kleiner als bei bekannten Induktivsensoren ausgelegt werden.

Das Meßsignal IM, das dem Steuergerät 12 zugeführt wird, kann dort in üblicher Weise mit Hilfe einer Pegelüberwachung, also einem Vergleich des Signalpegels (Strom oder Spannung) mit einem Referenzpegel daraufhin untersucht werden, ob ein Kurzschluß in einer der Zuleitungen oder eine Unterbrechung in einer der Zuleitungen oder eine Unterbrechung in der Spule vorhanden ist.

Die bisher beschriebene Schaltungsanordnung kann um zwei Widerstände R3 und gegebenenfalls R4 ergänzt werden, die zwischen der Basis des Transistors T2 und der Spule 11 bzw. zwischen dem Emitter des Transistors T1 und der Zweidrahtschnittstelle 13 liegen.

Der Widerstand R3 kompensiert dann den Spannungsabfall über dem Widerstand der Spule und gegebenenfalls des Widerstandes R4. Die Widerstandskombination R3 und R4 kompensiert einen Teil der temperaturabhängigen Widerstandsänderung des Widerstandes der Spule 11.

In Figur 2 ist schematisch dargestellt, wie die Sensoreinheit, also die Sensorspule 11 samt zugehöriger Auswerteschaltung zur Erfassung der Drehzahl eines um eine Achse 14 rotierenden Körpers 15 verwendet werden kann. Es ist dabei zu erkennen, daß der rotierende Körper 14 an seiner Oberfläche eine Winkelmarke 16 oder mehrere Winkelmarken 16, 16a, 16b aufweist, bei deren Vorbeilaufen in der Spule 11 eine Spannung bzw. ein Strom induziert wird, die bzw. der mit Hilfe der Stromspiegelschaltung verstärkt wird und letztendlich als Meßstrom IM zur weiteren Auswertung, beispielsweise im Steuergerät 12 zur Verfügung steht.

Mit der in Figur 2 dargestellten Anordnung entsteht ein pulsförmiger Meßstrom IM, aus den zeitlichen Abständen der einzelnen Impulse lassen sich in üblicher Weise die gewünschten Drehzahlen ermitteln. Es lassen sich nahezu beliebige rotierende oder bewegbare Körper abtasten.

Der Abstand zwischen der Sensorspule 11 und dem abzutastenden Körper ist so zu wählen, daß in der Spule wenigstens noch ein minimaler Strom induziert wird, dieser Abstand kann wegen der direkt folgenden Signalverstärkung größer sein als bei bekannten Induktivsensoren .

**Patentansprüche**

1. Schaltungsanordnung zur Signalaufbereitung für einen, eine Induktivität umfassenden Sensor, zur Abtastung eines bewegbaren Teiles, insbesonders einen Drehzahlsensor, wobei die Schaltungsanordnung die Induktivität des Sensors, einen ersten Transistor (T1), dessen Kollektor mit der Basis verbunden ist und einen zweiten Transistor (T2) umfaßt, wobei die Kollektoren der Transistoren über je einem Widerstand (R1, R2) miteinander und mit einem Versorgungsspannungsanschluß in Verbindung stehen und die Emitter ebenfalls miteinander in Verbindung stehen und der Sensor zwischen den Basen der Transistoren geschaltet ist und der zweite Transistor (T2) eine Stromverstärkung des Sensormeßstromes bewirkt, dadurch gekennzeichnet, daß die Emitter der Transistoren (T1, T2) mit einem Anschluß eines Widerstandes (RM), an dem ein Meßsignal abgreifbar ist, in Verbindung stehen.

2. Schaltungsanordnung nach Anspruch 1, dadurch gekennzeichnet, daß parallel zur Induktivität des Sensors zwei antiparallel geschaltete Dioden (D1, D2) liegen.

3. Schaltungsanordnung nach einem der vorhergehenden Ansprüche, dadurch gekennzeichnet, daß die Induktivität (L1) eine Spule ist und die Spule und die Transistorschaltung eine Einheit bilden.

4. Schaltungsanordnung nach Anspruch 3, dadurch gekennzeichnet, daß zwischen der Basis des zweiten Transistors (T2) und der Spule (11) ein weiterer Widerstand (R4) und zwischen dem Emitter des ersten Transistors (T1) und dem Anschluß des Meßwiderstands (RM) ein Widerstand (R3) liegt.

5. Schaltungsanordnung nach einem der vorhergehenden Ansprüche, dadurch gekennzeichnet, daß die Induktivität (L1) des Sensors durch vorbeibewegte Teile (16, 16a, 16b) mit einer charakteristischen Oberfläche beeinflußt werden kann, so daß sich das Meßsignal in Abhängigkeit von der Oberfläche der vorbeibewegten Teile und ihrer Geschwindigkeit ändert.

6. System, umfassend eine Schaltungsanordnung nach einem der vorhergehenden Ansprüche, das bewegbare Teil (15) nach Anspruch 1 und eine Steuereinrichtung (12), insbesondere ein Steuergerät eines Kraftfahrzeuges, wobei der Steuereinrichtung (12) das verstärkte Signal zugeführt wird, das dann in der Steuereinrichtung ausgewertet wird, wobei die Drehzahl des abgetasteten Teils ermittelt wird und wobei das abgetastete Teil (15) ein Rad oder eine sich drehende Welle ist.

7. System nach Anspruch 6, dadurch gekennzeichnet, daß die Steuereinrichtung (12) eine Überwachung des Pegels des zugeführten Signales durchführt und bei erkannten Unplausibilitäten im Signalpegel einen Fehler erkennt und eine entsprechende Anzeige auslöst.

**Claims**

1. Signal-conditioning circuit arrangement for a sensor comprising an inductance, for sensing a movable part, in particular a rotational speed sensor, the circuit arrangement comprising the inductance of the sensor, a first transistor (T1), whose collector is connected to the base, and a second transistor (T2), the collectors of the transistors being connected via a respective resistor (R1, R2) to one another and to a supply voltage terminal, and the emitters likewise being connected to one another, and the sensor being connected between the bases of the transistors, and the second transistor (T2) effecting current amplification of the sensor measurement current, characterized in that the emitters of the transistors (T1, T2) are connected to a terminal of a resistor (RM) at which a measurement signal can be picked off.

2. Circuit arrangement according to Claim 1, characterized in that two reverse-connected parallel diodes (D1, D2) are connected in parallel with the inductance of the sensor.

3. Circuit arrangement according to one of the preceding claims, characterized in that the inductance (L1) is a coil, and the coil and the transistor circuit form a unit.

4. Circuit arrangement according to Claim 3, characterized in that a further resistor (R4) is connected between the base of the second transistor (T2) and the coil (11), and a resistor (R3) is connected between the emitter of the first transistor (T1) and the terminal of the measuring resistor (RM).

5. Circuit arrangement according to one of the preceding claims, characterized in that the inductance (L1) of the sensor can be influenced by parts (16, 16a, 16b) that are moved past and have a characteristic surface, with the result that the measurement signal changes as a function of the surface of the parts moved past and the speed thereof.

6. System comprising a circuit arrangement according to one of the preceding claims, the moveable part (15) according to Claim 1 and a control device (12), in particular a control unit of a motor vehicle, the amplified signal being fed to the control device (12) and then being evaluated in the control device, the rotational speed of the sensed part being determined and the sensed part (15) being a wheel or a rotating shaft.

7. System according to Claim 6, characterized in that the control device (12) carries out monitoring of the level of the signal fed thereto and, in the event of implausibilities detected in the signal level, detects an error and initiates a corresponding display.

**Revendications**

1. Circuit de traitement de signaux pour un capteur, qui comprend une inductance, servant à recueillir les signaux d'une pièce mobile, en particulier d'un capteur de vitesse de rotation, le circuit de traitement comprenant l'inductance du capteur, un premier transistor (T1), dont le collecteur est relié à la base, et un deuxième transistor (T2), les collecteurs des transistors étant en liaison l'un avec l'autre, chacun au moyen d'une résistance (R1, R2) et avec un raccord de tension d'alimentation, et les émetteurs étant également reliés l'un avec l'autre et le capteur étant monté entre les bases des transistors, et le deuxième transistor (T2) assurant une amplification de l'intensité de mesure du capteur,

caractérisé en ce que
les émetteurs des transistors (T1, T2) sont en liaison avec un raccord d'une résistance (RM), sur laquelle on peut prélever un signal de mesure.

2. Circuit selon la revendication 1,
caractérisé en ce que
parallèlement à l'inductance du capteur il y a deux diodes (D1, D2) selon un montage antiparallèle.

3. Circuit selon l'une des revendications précédentes,
caractérisé en ce que
l'inductance (L1) est une bobine et la bobine et le circuit des transistors forment une unité.

4. Circuit selon la revendication 3,
caractérisé en ce qu'
entre la base du deuxième transistor (T2) et la bobine (11) il y a une autre résistance (R4) et entre l'émetteur du premier transistor (T1) et le raccord de la résistance de mesure (RM) il y a une résistance (R3).

5. Circuit selon l'une des revendications précédentes,
caractérisé en ce que
l'inductance (L1) du capteur peut être influencée par les pièces qui passent devant lui (16, 16a, 16b) avec une surface caractéristique, de telle sorte que le signal de mesure se modifie en fonction de la surface des pièces qui passent devant et de leur vitesse.

6. Système, comprenant un circuit selon l'une des revendications précédentes, la pièce mobile (15) selon la revendication 1 et un dispositif de commande (12), en particulier un appareil de commande d'un véhicule à moteur,
dans lequel
on amène au dispositif de commande (12) le signal amplifié, qui est alors exploité dans le dispositif de commande, la vitesse de rotation de la pièce dont on recueille les signaux étant déterminée et la pièce (15) dont on recueille les signaux étant une roue ou un arbre qui tourne.

7. Système selon la revendication 6,
caractérisé en ce que
le dispositif de commande (12) effectue un contrôle du niveau du signal amené et quand un défaut de plausibilité a été détecté dans le niveau du signal le dispositif détecte une erreur et déclenche un avertissement correspondant.

Fig.1

Fig.2